# EUROPÄISCHE PATENTSCHRIFT

(11) **EP 4 058 815 B1**
(45) Veröffentlichungstag und Bekanntmachung des Hinweises auf die Patenterteilung: **13.12.2023**
(21) Anmeldenummer: 20800925.8
(22) Anmeldetag: 04.11.2020
(51) Int. Cl.: G01R 15/06, G01R 15/16

(54) **SPANNUNGSSENSOR UND SPANNUNGSTEILUNGSVORRICHTUNG**
VOLTAGE SENSOR AND VOLTAGE DIVIDING DEVICE
CAPTEUR DE TENSION ET DISPOSITIF DE DIVISION DE TENSION

(30) Priorität: 14.11.2019 AT 509842019
(43) Veröffentlichungstag der Anmeldung: 21.09.2022
(73) Patentinhaber: Greenwood-Power GmbH, 2471 Rohrau (AT)
(72) Erfinder: JUSCHICZ, Norbert, 2404 Petronell-Carnuntum (AT); BACHER, Willibald, 2404 Petronell-Carnuntum (AT)
(74) Vertreter: Puchberger & Partner Patentanwälte
(86) Internationale Anmeldenummer: PCT/EP2020/080971
(87) Internationale Veröffentlichungsnummer: WO 2021/094166

(56) Entgegenhaltungen:
- EP-A1- 3 211 435
- WO-A1-2019/186607

## Beschreibung

Spannungssensoren werden in Schaltanlagen von Stromnetzen bei der Messung der elektrischen Spannung eingesetzt. Aus dem Stand der Technik ist es bekannt, als Spannungssensor einen hochohmigen Widerstand zu benutzen, und diesen in einem ohmschen Spannungsteiler einzusetzen. Diese verfügen über zumindest zwei in Serie geschaltete elektrische Widerstände, wodurch die Spannung des zu messenden Hochspannungs-Primärkreises entsprechend dem Verhältnis der Widerstände aufgeteilt wird. Rein ohmsche Spannungsteiler haben jedoch den Nachteil, dass beispielsweise vom Verbindungskabel oder von den weiteren Bauelementen stammende Streukapazitäten und/oder parasitische Kapazitäten einen großen Einfluss auf den tatsächlichen Messwert und somit auf die Messgenauigkeit haben.

Zur Messung von hohen Wechselspannungen sind ohmsch-kapazitive Spannungsteiler bekannt, welche im Sekundärkreis als Spannungssensor wenigstens einen elektrischen Widerstand und einen parallel dazu geschalteten elektrischen Kondensator mit einer vorab definierten Kapazität aufweisen. Ohmsch-kapazitive Spannungsteiler werden regelmäßig in Mittelspannungsschaltanlagen zwischen 10 kV und 30 kV eingesetzt. Sie teilen die hohe Wechselspannung der Primärseite zur Messung in eine äquivalente niedrigere Wechselspannung auf der Sekundärseite.

Ohmsch-kapazitive Spannungsteiler umfassen eine erste Widerstand-Kondensator-Parallelschaltung und, als Spannungssensor, eine zweite Widerstand-Kondensator-Parallelschaltung, wobei die beiden Widerstand-Kondensator-Parallelschaltungen elektrisch in Serie angeordnet sind. Der elektrische Widerstand der ersten Parallelschaltung ist wesentlich höher als jener der zweiten Parallelschaltung, sodass der Spannungsabfall an der zweiten Parallelschaltung, dem eigentlichen Spannungssensor, in einer niedrigen Relation zur Hochspannung steht.

Ein Hauptproblem derartiger ohmsch-kapazitiver Spannungsteiler ist, dass die Kapazität der Kondensatoranordnung über lange Zeiträume - in der Regel mehrere Jahre oder sogar Jahrzehnte - möglichst konstant bleiben soll, um ein Driften des tatsächlichen Messwerts zu vermeiden. Ferner ist eine Konstanz der Kapazität des Kondensators bei Veränderungen der Außentemperatur oder bei geringfügiger Änderung der Frequenz des Stromes notwendig. Zusätzlich kann die Aufnahme von Feuchtigkeit in das zwischen den Kondensatorelementen befindliche Dielektrikum während der Lebensdauer des Spannungsteilers zu einer Veränderung der Kapazität führen.

Eine gattungsgemäße Spannungsteilungsvorrichtung ist in der EP 3 211 435 A1 gezeigt. Hier sind die Elektroden becherförmig ausgebildet. Eine weitere Spannungsteilungsvorrichtung, die jedoch eine rein kapazitive Vorrichtung ist und nur zwei Elektroden aufweist ist in der WO 2019/186607 A1 gezeigt.

Es ist die Aufgabe der vorliegenden Erfindung, die Nachteile des Standes der Technik zu überwinden und einen Spannungssensor sowie eine Spannungsteilungsvorrichtung zu schaffen, die über einen langen Zeitraum, insbesondere über mehrere Jahre oder Jahrzehnte, eine konstante Kapazität aufweist und die dielektrische Festigkeit über die gesamte Lebensdauer der Spannungsteilungsvorrichtung zu halten.

Die Aufgabe der Erfindung wird durch die kennzeichnenden Merkmale der unabhängigen Patentansprüche gelöst.

Der erfindungsgemäße Spannungssensor umfasst einen elektrischen Hochspannungsanschluss, einen elektrischen Signalanschluss sowie einem Erdungsanschluss. Die zu messende Spannung wird im Betrieb an den Hochspannungsanschluss angelegt. Der Spannungssensor umfasst einen Kernbereich mit einem darin angeordneten elektrischen Widerstand und einer darin angeordneten Kondensatoranordnung. Dieser Kernbereich ist vorzugsweise hermetisch abgeschlossen und mit einem isolierenden Material gefüllt.

Erfindungsgemäß umfasst die Kondensatoranordnung im Kernbereich eine erste Elektrode, die mit dem Hochspannungsanschluss verbunden ist, und eine zweite Elektrode, die mit dem Signalanschluss verbunden ist. Die erste Elektrode und die zweite Elektrode sind beabstandet und nur über den elektrischen Widerstand elektrisch leitend verbunden, sodass sich eine Widerstand-Kondensator-Parallelschaltung zur Bildung eines ohmsch-kapazitiven Spannungsteiler bildet.

Erfindungsgemäß weist die Kondensatoranordnung eine dritte Elektrode auf, die mit dem Erdungsanschluss verbunden ist. Die erste Elektrode, die zweite Elektrode und die dritte Elektrode umfassen jeweils mehrere elektrisch leitende, im Wesentlichen fingerförmige oder stabförmige Aussteuerungselemente. Die Aussteuerungselemente verlaufen parallel zur Längsachse des Spannungssensors.

Gasgefüllte Hohlräume erhöhen das Potenzial von Spannungsüberschlägen und verhindern die vollständige Entladung der Spannungsteilungsvorrichtung, was für einen zuverlässigen Betrieb unerwünscht ist. Dies ist insbesondere wichtig, wenn die Kondensatoranordnung in einem festen Dielektrikum eingebettet ist, beziehungsweise der Kernbereichdurch ein festes Dielektrikum ausgefüllt ist. Gegebenenfalls kann dazu ein den Kernbereich ausfüllendes Polymer vorgesehen sein.

Durch die fingerförmige oder stabförmige Ausgestaltung und den runden Querschnitt bzw. der Zylinderform der Aussteuerungselemente wird die Möglichkeit der Bildung von Ablösungen und damit das Vorhandensein von gasgefüllten Hohlräumen beispielsweise durch Schrumpfen des Dielektrikums während des Herstellungsprozesses der Spannungsteilungsvorrichtung reduziert.

Ferner können sich die stabförmigen Aussteuerungselemente leichter an Temperaturschwankungen anpassen, was bei ringförmigen Elektrodenanordnungen nicht der Fall ist. Im Wesentlichen können die fingerförmigen oder stabförmigen Aussteuerungselemente im Produktionsprozess und bei Temperaturschwankungen mit dem dielektrischen Medium "mitwandern".

Gegebenenfalls ist vorgesehen, dass die Aussteuerungselemente jeweils kreisförmig angeordnet sind. Insbesondere können die Aussteuerungselemente zueinander im Wesentlichen konzentrisch angeordnet sein.

Dadurch wird eine möglichst große Kondensatorfläche bei geringem Platzbedarf ermöglicht. Durch eine Anordnung in konzentrischen Kreisen kann zusätzlich der Abstand zwischen den Kondensatorelementen konstant bleiben.

Gegebenenfalls sind die Aussteuerungselemente der ersten Elektrode und die Aussteuerungselemente der zweiten Elektrode im Wesentlichen im gleichen Radius angeordnet, vorzugsweise in einem Radius von etwa 8 mm bis etwa 22 mm.

Erfindungsgemäß können die Aussteuerungselemente der dritten Elektrode in einem Radius außerhalb der Aussteuerungselemente der ersten und zweiten Elektroden angeordnet sein, vorzugsweise in einem Radius im Bereich von etwa 15 mm bis etwa 40 mm. Dies hat den Vorteil, dass das Erdpotential der dritten Elektrode die darunterliegende erste und zweite Elektrode vor äußeren Einflüssen abschirmt.

Der Radius der kreisförmigen Anordnung der Aussteuerungselemente der dritten Elektrode kann um etwa 50% größer sein als der Radius der kreisförmigen Anordnung der Aussteuerungselemente der ersten und zweiten Elektroden.

Die Aussteuerungselemente können jeweils eine Länge von etwa 10 mm bis etwa 60 mm und einen Durchmesser von jeweils etwa 1,5 mm bis etwa 10 mm aufweisen.

Bei der Dimensionierung der Aussteuerungselemente kann auf deren radialen Abstand Wert gelegt werden. Ist der Abstand zwischen den Aussteuerungselementen groß genug, kann die Gefahr von Spannungsüberschlägen zwischen den Aussteuerungselementen und eine damit verbundene etwaige Beschädigung des Dielektrikums verhindert werden. Eine Anpassung des Abstandes kann in Abstimmung mit den Betriebsbedingungen, insbesondere in Abstimmung mit der Eingangsspannung, erfolgen.

Erfindungsgemäß kann vorgesehen sein, dass die Aussteuerungselemente der ersten Elektrode und die Aussteuerungselemente der zweiten Elektrode entlang ihrer Längsausdehnungsrichtung keinen Überlappungsbereich aufweisen. Die Spitzen der Aussteuerungselemente können etwa 3 mm bis etwa 25 mm beabstandet sein.

Dadurch kann der beabsichtigte Kapazitätswert zwischen der ersten Elektrode und der zweiten Elektrode erreicht werden.

Erfindungsgemäß kann vorgesehen sein, dass die Aussteuerungselemente jeweils einen im Wesentlichen elektrisch isolierenden Grundkörper und eine elektrisch leitende Beschichtung aufweisen. Erfindungsgemäß kann auch vorgesehen sein, dass die Aussteuerungselemente jeweils ein elektrisch leitendes Additiv und eine im Wesentlichen elektrisch isolierende Grundmasse umfassen, wobei das Additiv vorzugsweise Kohlenstoff-Nanopartikel umfasst oder aus Kohlenstoff-Nanopartikeln besteht.

Durch die Verwendung eines elektrisch isolierenden Grundkörpers bzw. durch die Hinzufügung eines elektrisch leitenden Additivs zu einer im Wesentlichen elektrisch isolierenden Grundmasse können die Ausdehnungskoeffizienten von Dielektrikum und Aussteuerungselementen aneinander angenähert werden. Dadurch werden die Ablösung der Aussteuerungselemente und die damit verbundene unerwünschte Hohlraumbildung weiter reduziert. Vorzugsweise wird als Grundkörper bzw. als Grundmasse ein Epoxidharz eingesetzt. Insbesondere im Vergleich zu vollmetallischen Aussteuerungselementen kann so die Hohlraumbildung stark reduziert werden.

Gegebenenfalls ist vorgesehen, dass die Längsausdehnungsrichtung der Aussteuerungselemente im Wesentlichen parallel verlaufen. Damit kann ein im Wesentlichen durchgehend konstanter Abstand zwischen den Aussteuerungselementen erreicht werden. Dies kann insbesondere eine konstante Kapazität der Kondensatoranordnung begünstigen.

Gegebenenfalls ist vorgesehen, dass die Aussteuerungselemente der dritten Elektrode die Aussteuerungselemente der ersten und zweiten Elektrode in einer Richtung parallel zu ihrer Längsausdehnungsrichtung zumindest teilweise, vorzugsweise vollständig, überlappen. Durch die Breite des Überlappungsbereichs kann die Abschirmung der ersten und zweiten Elektrode gegen äußere Störeinflüsse verbessert werden.

Gegebenenfalls ist vorgesehen, dass die erste Elektrode und die zweite Elektrode jeweils sechs bis vierzehn, vorzugsweise acht bis zwölf, Aussteuerungselemente aufweist. Die dritte Elektrode hat in der Regel einen größeren Umfang und kann 14 bis 26, vorzugsweise 18 bis 22, Aussteuerungselemente aufweisen.

Gegebenenfalls ist vorgesehen, dass die Kondensatoranordnung eine Kapazität von 0,1 pF bis 30 pF, vorzugsweise von 0,5 pF bis 15 pF, bei einer Temperatur von 20°C, einer relativen Luftfeuchtigkeit von 50%, einem Druck von 1000 mbar und einer Stromfrequenz von 50 Hz aufweist. Eine ausreichend große Kapazität der Kondensatoranordnung ermöglicht die Vernachlässigung von Streukapazitäten und parasitischen Kapazitäten bei der Spannungsmessung. Dadurch werden die genannten Restkapazitäten im Vergleich zur Hauptkapazität des Kondensators so gering, dass diese keinen wesentlichen Einfluss mehr auf die Genauigkeit der Messung haben.

Gegebenenfalls ist vorgesehen, dass der Kernbereich ein Dielektrikum umfasst, welches ein Siloxan-basiertes Polymer umfasst oder aus einem Siloxan-basierten Polymer besteht. Siloxan-basierte Polymere, insbesondere feste Siloxan-Polymere, auch als Silikon-Polymere bekannt, weisen diffusionshemmende Eigenschaften auf. Derartige Polymere als Dielektrikum sind weitestgehend unempfindlich gegenüber Wasserdampfdiffusion und es zeigen sich keine nennenswerten Veränderungen der Dielektrizitätskonstante, wenn diese Luftfeuchtigkeit ausgesetzt werden. Ferner ist das Frequenzübertragungsverhalten von Silikon-Polymeren im Vergleich zu bekannten Dielektrika besser, womit normgerechte Anforderungen, insbesondere betreffend den internationalen Standard IEC 61869-11, erfüllt werden können. Zusätzlich können innerhalb der vorgegebenen Grenzen bis zu 150 kHz übertragen werden.

Siloxan-basierte Polymere, insbesondere feste Siloxan-Polymere, auch als Silikon-Polymere bekannt haben elastische Eigenschaften. In einem erfindungsgemäßen Spannungssensor kann sich das Polymer dadurch gut an die Struktur der Elektrodenanordnung anpassen. Bei unelastischen Materialien können beispielsweise bei Temperaturschwankungen im Material Risse auftreten oder das Material der Kondensatoranordnung kann sich wenigstens teilweise vom Dielektrikum lösen.

Dies kann zu einer Bildung von gasgefüllten Hohlräumen führen, welche einerseits eine Konstanz der Kapazität der Kondensatoranordnung verhindern und andererseits zu Spannungsüberschlägen und einer nur unvollständigen Entladung des Spannungssensors führen können. Diese Probleme können mit einem Siloxan-basierten Polymer vermieden werden, da eine gute Verbindung mit den Elementen der Kondensatoranordnung gewährleistet wird.

Gegebenenfalls kann vorgesehen sein, dass der Kernbereich im Wesentlichen kegelstumpfförmig oder im Wesentlichen zylinderförmig ausgebildet ist. Gegebenenfalls kann vorgesehen sein, dass ein Mantelbereich, vorzugsweise ein Mantelbereich aus Epoxid-basiertem Polymer, vorgesehen ist, der den Kernbereich zumindest teilweise, vorzugsweise komplett, umgibt.

Aufgrund der typischen elastischen Eigenschaften von Siloxan-Polymeren kann es vorteilhaft sein, den aus Siloxan-Polymer gebildeten Kernbereich von einem mechanisch stabileren Mantelbereich zu umgeben und dadurch vor Verformung und Zerstörung zu schützen.

Gegebenenfalls kann vorgesehen sein, dass das Dielektrikum des Kernbereichs eine relative Dielektrizitätskonstante von 2 bis 8 aufweist. Gegebenenfalls kann vorgesehen sein, dass sich die relative Dielektrizitätskonstante des Dielektrikums des Kernbereichs in einem Temperaturbereich von -40°C bis 80°C im Vergleich zur relativen Dielektrizitätskonstante des Dielektrikums bei 20°C um höchstens 3%, vorzugsweise um höchstens 0,75%, verändert.

Da der Einsatzbereich des erfindungsgemäßen Spannungssensors üblicherweise in nicht klimatisierten oder geheizten Bereichen ist, ist es vorteilhaft, wenn die Dielektrizitätskonstante des Dielektrikums in einem typischerweise unter normalen Umweltbedingungen auftretenden Temperaturbedingungen möglichst konstant ist. Dadurch wird eine gleichmäßige Kapazität der Kondensatoranordnung gewährleistet, was für eine möglichst genaue Spannungsmessung von Vorteil ist.

Gegebenenfalls kann vorgesehen sein, dass sich die relative Dielektrizitätskonstante des Dielektrikums des Kernbereichs in einem Frequenzbereich von 50 Hz bis 150000 Hz im Vergleich zur relativen Dielektrizitätskonstante des Dielektrikums bei 50 Hz um höchstens 0,6%, vorzugsweise um höchstens 0,4%, verändert.

Durch die Einspeisung verschiedenartiger Energiequellen kann es in modernen Stromnetzen zu einer Variation der Netzfrequenz kommen. Deshalb ist es vorteilhaft, wenn die Dielektrizitätskonstante des Dielektrikums auch in einem für Stromnetze typischen Frequenzbereich konstant ist, um eine exakte Messung der Spannung zu gewährleisten.

Gegebenenfalls kann vorgesehen sein, dass sich die relative Dielektrizitätskonstante des Dielektrikums des Kernbereichs bei einem Wasseranteil des Dielektrikums von 5‰ bis 30‰ um höchstens 3%, vorzugsweise um höchstens 2,9% im Vergleich zur relativen Dielektrizitätskonstante des Dielektrikums bei einem Wassergehalt von 30‰, verändert.

Da der erfindungsgemäße Spannungssensor typischerweise unter normalen Umweltbedingungen verwendet wird, kann es auch vorkommen, dass diese erhöhter Luftfeuchtigkeit ausgesetzt ist. Siloxan-basierte Polymere weisen üblicherweise eine geringe Wasseraufnahmefähigkeit auf. Dennoch ist es vorteilhaft, wenn die Dielektrizitätskonstante des Dielektrikums über einen gewissen Bereich des Wassergehalts möglichst konstant ist, um auch über lange Zeiträume hinweg konstante Messergebnisse für die Spannung zu erzielen. Insbesondere würde eine starke Abhängigkeit der Dielektrizitätskonstante vom Wassergehalt des Dielektrikums zu einem unerwünschten zeitlichen Drift des Messwertes führen, wenn mit der Betriebsdauer des Spannungssensors immer mehr Wasser in das Dielektrikum eindiffundiert.

Gegebenenfalls kann vorgesehen sein, dass der Kernbereich aus einem zweikomponentigen Siloxan-System vergossen wird.

Gegebenenfalls kann vorgesehen sein, dass die maximale Wasseraufnahmefähigkeit bei einer Temperatur von 20°C 30‰ des Eigengewichtes der Polymermasse beträgt. Die maximale Wasseraufnahmefähigkeit kann beispielsweise durch Lagern des Silikon-Polymers für etwa 1000 Tage in einer Klimakammer bestimmt werden.

Die Erfindung betrifft ferner eine Spannungsteilungsvorrichtung mit einem erfindungsgemäßen Spannungssensor sowie die Anordnung einer erfindungsgemäßen Spannungsteilungsvorrichtung an einem Verbindungsteil einer Schaltanlage eines Stromnetzes.

Weitere Merkmale der Erfindung ergeben sich aus den Patentansprüchen, den Ausführungsbeispielen sowie aus den Figuren.

Im Folgenden wird die Erfindung anhand eines nicht ausschließlichen Ausführungsbeispiels im Detail erläutert. Es zeigen:
Fig. 1 eine seitliche Schnittansicht eines erfindungsgemäßen Spannungssensors;
Fig. 2 eine Schnittansicht eines erfindungsgemäßen Spannungssensors entlang der Achse A-A aus Fig. 1;
Fig. 3 eine schematisches Schaltbild einer erfindungsgemäßen Spannungsteilungsvorrichtung zur Messung einer Hochspannung mit einem erfindungsgemäßen Spannungssensor.

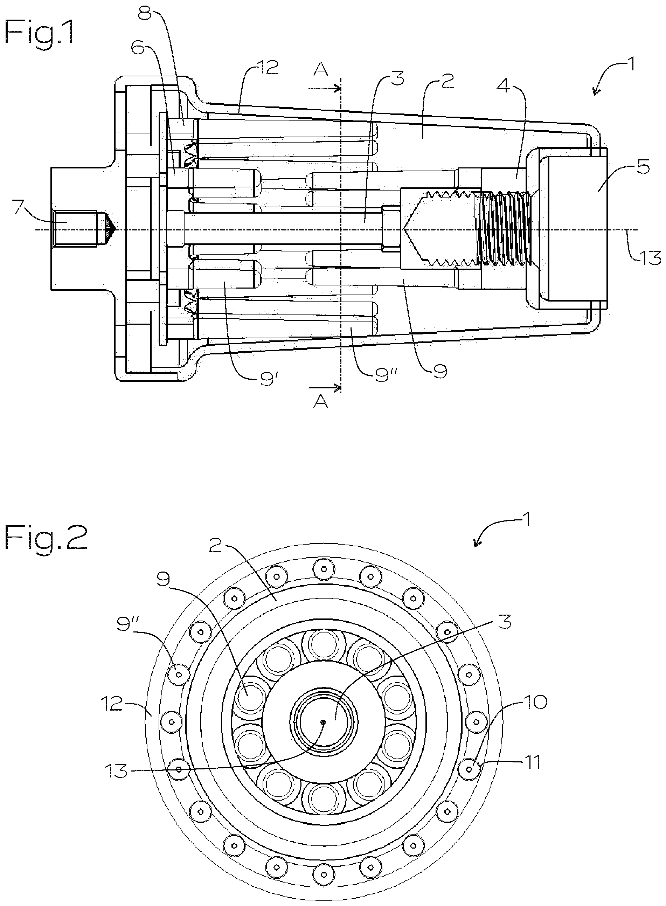

Fig. 1 zeigt eine Ausführungsform eines erfindungsgemäßen Spannungssensors 1 in einer Schnittansicht entlang einer Ebene, die durch eine Längsachse 13 des Spannungssensors 1 verläuft. Der Spannungssensor 1 ist im Wesentlichen konusförmig und symmetrisch zur Längsachse 13. Der Spannungssensor 1 umfasst einen Kernbereich 2 mit einer Kondensatoranordnung, die eine erste Elektrode 4, eine zweite Elektrode 6 und eine dritte Elektrode 8 aufweist. Die erste Elektrode 4 und die zweite Elektrode 6 sind an entgegengesetzten Enden des Spannungssensors 1 vorgesehen.

Die erste Elektrode 4 ist mit einem Hochspannungsanschluss 5 verbunden. Im Betrieb wird die zu messende Spannung an diesen ersten elektrischen Anschluss 5 angelegt.

Die zweite Elektrode 6 ist mit einem Signalanschluss verbunden, der als Messleitung dient. Die zweite Elektrode 6 ist über einen nicht dargestellten Messwiderstand R2 und einen nicht dargestellten Messkondensator C2 mit einem Erdungsanschluss 7 verbunden. Der Messwiderstand und der Messkondensator können auf einer Leitungsplatte im Inneren des Spannungssensors 1 angeordnet sein.

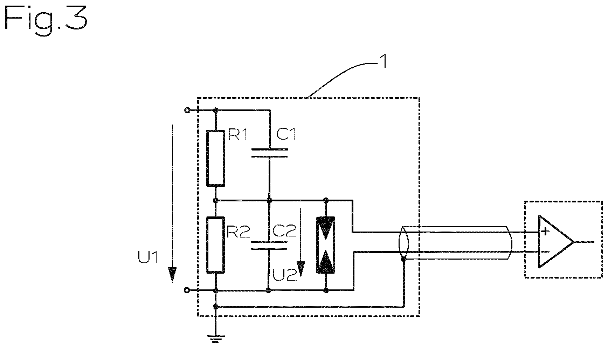

Zwischen dem Hochspannungsanschluss 5 und dem Signalanschluss ist ein hoher elektrischer Widerstand 3 vorgesehen, der sich entlang der Längsachse 13 im Zentrum des Spannungssensors 1 erstreckt. Gemeinsam mit der Kondensatoranordnung wird durch den Widerstand 3 eine Widerstands-Kondensator-Kombination R1 / C1 zur Teilung der Hochspannung gebildet, wie in Fig. 3 dargestellt.

Die Kondensatoranordnung umfasst ferner eine dritte Elektrode 8, die direkt mit dem Erdungsanschluss 7 verbunden ist. Die dritte Elektrode 8 ist außerhalb der ersten und zweiten Elektroden 4, 6 angeordnet, um diese gegenüber störenden Einflüssen von außerhalb des Spannungssensors 1 abzuschirmen.

Die erste Elektrode 4, die zweite Elektrode 6 und die dritte Elektrode 8 weisen jeweils in konzentrischen Kreisen zueinander angeordnete Aussteuerungselemente 9, 9', 9" auf, wobei die Aussteuerungselemente fingerförmig ausgebildet sind und im Wesentlichen parallel zur Längsachse 13 des Spannungssensors verlaufen.

Die Aussteuerungselemente 9 der ersten Elektrode 4 und die Aussteuerungselemente 9' der zweiten Elektrode 6 sind kreisförmig in einem Radius von etwa 15mm angeordnet. Die Aussteuerungselemente 9" der dritten Elektrode 8 sind ebenfalls kreisförmig und konzentrisch außerhalb der Aussteuerungselemente 9, 9' in einem Radius von etwa 25 mm angeordnet.

Die Aussteuerungselemente 9 der ersten Elektrode 4 und die Aussteuerungselemente 9' der zweiten Elektrode 6 ragen in entgegengesetzte Richtungen im Kernbereich 2 aufeinander zu und weisen entlang ihrer Längsausdehnungsrichtung keinen Überlappungsbereich auf. Die Spitzen der Aussteuerungselemente 9, 9' sind etwa um 3 mm beabstandet. Hingegen überlappen die außenliegenden Aussteuerungselemente 9" der dritten Elektrode 8 die Aussteuerungselemente 9 der ersten Elektrode 4 in ihrer Längsausdehnungsrichtung teilweise, und zwar um einen Überlappungsbereich von etwa 15 mm, und die Aussteuerungselemente 9' der zweiten Elektrode 6 vollständig.

In diesem Ausführungsbeispiel sind Kondensatoranordnung und Widerstand 3 von einem Kernbereich 2 umgeben, welcher aus einem elastischen Material auf Siloxan-Polymerbasis gebildet wird. Da es sich bei dem Siloxan-Polymer in diesem Ausführungsbeispiel um ein elastisch-weiches Material handelt, ist der Kernbereich 2 zur Erhöhung der mechanischen Stabilität in diesem Ausführungsbeispiel von einer aus einem Epoxid-basierten Polymer bestehenden Mantelbereich 12 umgeben. Das Siloxan-Polymer in diesem Ausführungsbeispiel weist im Vergleich zu typischerweise verwendeten Kunststoffmaterialien, wie etwa Epoxid-Polymeren eine geringe Wasserdiffusion auf.

Fig. 2 zeigt eine Schnittansicht des in Fig. 1 dargestellten Spannungssensors 1 entlang der Achse A-A. In Fig. 2 zeigt sich der im Wesentlichen konzentrische Aufbau der Elemente des Spannungssensors 1. Der elektrische Widerstand 3 ist im Zentrum entlang der Zentralachse 13 verlaufend angeordnet. Die Aussteuerungselemente 9 der ersten Elektrode 4 und die Aussteuerungselemente 9' der zweiten Elektrode 6 sind in einem inneren Kreis konzentrisch zum Widerstand 3 angeordnet. Die Aussteuerungselemente 9" der dritten Elektrode 8 sind konzentrisch dazu in einem äußeren Kreis angeordnet.

In diesem Ausführungsbeispiel weisen die Aussteuerungselemente 9, 9', 9" einen im Wesentlichen elektrisch isolierenden Grundkörper 10 auf, welcher mit einer elektrisch leitenden Beschichtung 11, insbesondere mit einem Leitlack, beschichtet ist, um mit der ersten Elektrode 4, der zweiten Elektrode 6 bzw. der dritten Elektrode 8 in elektrisch leitender Verbindung zu stehen.

In anderen Ausführungsbeispielen können die Aussteuerungselemente 9, 9', 9" auch vollständig aus elektrisch leitendem Material gebildet sein oder aus einem elektrischen Isolator, welcher durch Zugabe von Additiven elektrisch leitend ist.

In diesem Ausführungsbeispiel beträgt der Abstand zwischen den Radien der beiden Kreise, die die Anordnung der Aussteuerungselemente 9, 9' und 9"beschreiben, etwa 7,6mm. In anderen Ausführungsbeispielen kann der Abstand jedoch auch andere Werte annehmen.

Fig. 3 eine schematisches Schaltbild einer erfindungsgemäßen Spannungsteilungsvorrichtung zur Messung einer Hochspannung mit dem Spannungssensor 1 aus Figs. 1 und 2. Der Spannungssensor 1 bildet einen ohmsch-kapazitiven Spannungsteiler bestehend aus einer Serienschaltung der Widerstand-Kondensator-Parallelschaltungen mit R1 und C1 sowie R2 und C2. Dabei bildet der oben beschriebene Widerstand 3 den Widerstand R1 und die oben beschriebene Kondensatoranordnung den Kondensator C1. Der eigentliche Messwiderstand R2 und der Messkondensator C2 befindet sich auf einer nicht dargestellten Platine im Inneren des Spannungssensors 1. Die Niederspannung U2 steht in einer bekannten Relation zu der zu messenden Hochspannung U1 und wird über ein erdgeschirmtes Messkabel an einen Messverstärker übertragen. Das Messkabel und der Erdungsanschluss 7 des Spannungssensors 1, somit auch die Aussteuerungselemente 9", sind geerdet.

Der in diesem Ausführungsbeispiel beschriebene Spannungssensor 1 weist einen maximalen Isolationswert von 24 kV auf. In anderen Ausführungsbeispielen kann der maximale Isolationswert jedoch auch 52 kV betragen. Auch beliebige andere maximale Isolationswerte sind je nach Anwendungsbereich möglich.

Der Spannungssensor 1 gemäß diesem Ausführungsbeispiel ist für eine nominelle Hochspannung U1 von maximal 24000/V3 V bei einer Frequenz von 50 Hz ausgelegt. Die Sekundär-Spannung U2 beträgt in diesem Ausführungsbeispiel etwa 3,25/V3 V, kann jedoch in anderen Ausführungsbeispielen je nach Anwendung angepasst werden.

In diesem Ausführungsbeispiel ist der Responsefaktor des Spannungssensors 1, also insbesondere die Kapazität der Kondensatoranordnung in einem Temperaturbereich von -40°C bis 80°C konstant. Insbesondere beträgt die Kapazität der Kondensatoranordnung, somit die Kapazität C1 in Fig. 3, in diesem Ausführungsbeispiel etwa 6 pF.

Die Erfindung beschränkt sich nicht auf das dargestellte Ausführungsbeispiel sondern umfasst auch alle weiteren Spannungssensoren und Spannungsteiler im Rahmen der nachfolgenden Patentansprüche.

### Bezugszeichenliste

- 1: Spannungssensor
- 2: Kernbereich
- 3: Widerstand
- 4: Erste Elektrode
- 5: Hochspannungsanschluss
- 6: Zweite Elektrode
- 7: Signalanschluss
- 8: Dritte Elektrode
- 9, 9', 9": Aussteuerungselement
- 10: Grundkörper
- 11: Beschichtung
- 12: Mantelbereich
- 13: Längsachse

## Patentansprüche

1. Spannungssensor (1) mit einem elektrischen Hochspannungsanschluss (5), einem elektrischen Signalanschluss sowie einem Erdungsanschluss (7), wobei der Spannungssensor (1) einen Kernbereich (2) mit einem darin angeordneten elektrischen Widerstand (3) und einer darin angeordneten Kondensatoranordnung umfasst, wobei die Kondensatoranordnung in einem Dielektrikum eingebettet ist und
- eine erste Elektrode (4) aufweist, die mit dem Hochspannungsanschluss (5) verbunden ist,
- eine zweite Elektrode (6) aufweist, die mit dem Signalanschluss verbunden ist,
- wobei die erste Elektrode (4) und die zweite Elektrode (6) über den elektrischen Widerstand (3) elektrisch leitend verbunden sind,
- wobei die Kondensatoranordnung eine dritte Elektrode (8) aufweist, die mit dem Erdungsanschluss (7) verbunden ist,
**dadurch gekennzeichnet, dass**
- die erste Elektrode (4), die zweite Elektrode (6) und die dritte Elektrode (8) jeweils mehrere elektrisch leitende, stabförmige Aussteuerungselemente (9, 9', 9") mit einem runden Querschnitt umfassen, die parallel zur Längsachse (13) des Spannungssensors (1) verlaufen, und dass
- die Aussteuerungselemente (9, 9', 9") derart ausgebildet sind, dass sie im Produktionsprozess und bei Temperaturschwankungen mit dem Dielektrikum mitwandern.

2. Spannungssensor nach Anspruch 1, **dadurch gekennzeichnet, dass** die Aussteuerungselemente (9, 9', 9") kreisförmig und vorzugsweise zueinander im Wesentlichen konzentrisch angeordnet sind.

3. Spannungssensor nach Anspruch 2, **dadurch gekennzeichnet, dass** die Aussteuerungselemente (9) der ersten Elektrode (4) und die Aussteuerungselemente (9') der zweiten Elektrode (6) im Wesentlichen im gleichen Radius angeordnet sind, vorzugsweise in einem Radius von etwa 8 mm bis etwa 22 mm.

4. Spannungssensor nach Anspruch 2 oder 3, **dadurch gekennzeichnet, dass** die Aussteuerungselemente (9") der dritten Elektrode (8) in einem Radius außerhalb der Aussteuerungselemente (9, 9') der ersten und zweiten Elektroden (4, 6) angeordnet sind, vorzugsweise in einem Radius im Bereich von etwa 15 mm bis etwa 40 mm.

5. Spannungssensor nach Anspruch 4, **dadurch gekennzeichnet, dass** der Radius der kreisförmigen Anordnung der Aussteuerungselemente (9") der dritten Elektrode (8) um etwa 50% größer ist als der Radius der kreisförmigen Anordnung der Aussteuerungselemente (9, 9') der ersten und zweiten Elektroden (4, 6).

6. Spannungssensor nach einem der Ansprüche 1 bis 5, **dadurch gekennzeichnet, dass** die Aussteuerungselemente (9, 9', 9") jeweils eine Länge von etwa 10 mm bis etwa 60 mm und einen Durchmesser von jeweils etwa 1,5 mm bis etwa 10 mm aufweisen.

7. Spannungssensor nach einem der Ansprüche 1 bis 6, **dadurch gekennzeichnet, dass** die Aussteuerungselemente (9) der ersten Elektrode (4) und die Aussteuerungselemente (9') der zweiten Elektrode (6) entlang ihrer Längsausdehnungsrichtung keinen Überlappungsbereich aufweisen.

8. Spannungssensor nach einem der Ansprüche 1 bis 7, **dadurch gekennzeichnet, dass** die Aussteuerungselemente (9, 9', 9") jeweils einen im Wesentlichen elektrisch isolierenden Grundkörper (10) und eine elektrisch leitende Beschichtung (11) aufweisen.

9. Spannungssensor nach einem der Ansprüche 1 bis 8, **dadurch gekennzeichnet, dass** die Aussteuerungselemente (9, 9', 9") jeweils ein elektrisch leitendes Additiv und eine im Wesentlichen elektrisch isolierende Grundmasse umfassen, wobei das Additiv vorzugsweise Kohlenstoff-Nanopartikel umfasst oder aus Kohlenstoff-Nanopartikeln besteht.

10. Spannungssensor nach einem der Ansprüche 1 bis 9, **dadurch gekennzeichnet, dass** die Aussteuerungselemente (9") der dritten Elektrode (8) die Aussteuerungselemente (9, 9') der ersten und zweiten Elektroden (4, 6) in ihrer Längsausdehnungsrichtung zumindest teilweise, vorzugsweise vollständig, überlappen.

11. Spannungssensor nach einem der Ansprüche 1 bis 10, **dadurch gekennzeichnet, dass** die erste Elektrode (4) und die zweite Elektrode (6) jeweils sechs bis vierzehn, vorzugsweise acht bis zwölf, Aussteuerungselemente (9, 9') aufweist, und dass die dritte Elektrode (8) 14 bis 26, vorzugsweise 18 bis 22, Aussteuerungselemente (9") aufweist.

12. Spannungssensor nach einem der Ansprüche 1 bis 11, **dadurch gekennzeichnet**, die Kondensatoranordnung eine Kapazität von 0,1 pF bis 30 pF, vorzugsweise von 0,5 pF bis 15 pF, bei einer Temperatur von 20°C, einer relativen Luftfeuchtigkeit von 50%, einem Druck von 1000 mbar und einer Stromfrequenz von 50 Hz aufweist.

13. Spannungssensor nach einem der Ansprüche 1 bis 12, **dadurch gekennzeichnet, dass** der Kernbereich (2) ein Dielektrikum umfasst, welches ein Siloxan-basiertes Polymer umfasst oder aus einem Siloxan-basierten Polymer besteht.

14. Spannungsteilungsvorrichtung, umfassen einen Spannungssensor (1) nach einem der Ansprüche 1 bis 13.

15. Anordnung einer Spannungsteilungsvorrichtung nach Anspruch 14 an einem Verbindungsteil einer Schaltanlage eines Stromnetzes.

## Claims

1. A voltage sensor (1) with an electrical high-voltage terminal (5), an electrical signal terminal and a ground terminal (7), wherein the voltage sensor (1) comprises a core area (2) with an electrical resistor (3) arranged therein and a capacitor arrangement arranged therein, wherein the capacitor arrangement is embedded in a dielectric, and
- has a first electrode (4), which is connected to the high-voltage terminal (5),
- has a second electrode (6), which is connected to the signal terminal,
- wherein the first electrode (4) and the second electrode (6) are electrically conductively connected via the electrical resistor (3),
- wherein the capacitor arrangement has a third electrode (8), which is connected to the ground terminal (7),
**characterised in that**
- the first electrode (4), the second electrode (6) and the third electrode (8) each comprise a plurality of electrically conductive, rod-shaped modulating elements (9, 9', 9") with a round cross-section, which extend parallel to the longitudinal axis (13) of the voltage sensor (1), and **in that**
- the modulating elements (9, 9', 9") are designed such that they travel with the dielectric during the manufacturing process and temperature variations.

2. The voltage sensor according to claim 1, **characterised in that** the modulating elements (9, 9', 9") are arranged in a circle and preferably substantially concentrically to each other.

3. The voltage sensor according to claim 2, **characterised in that** the modulating elements (9) of the first electrode (4) and the modulating elements (9') of the second electrode (6) are substantially arranged in the same radius, preferably in a radius of about 8 mm to about 22 mm.

4. The voltage sensor according to claim 2 or 3, **characterised in that** the modulating elements (9") of the third electrode (8) are arranged in a radius outside the modulating elements (9, 9') of the first and second electrodes (4, 6), preferably in a radius in the range of about 15 mm to about 40 mm.

5. The voltage sensor according to claim 4, **characterised in that** the radius of the circular arrangement of the modulating elements (9") of the third electrode (8) is larger by about 50 % than the radius of the circular arrangement of the modulating elements (9, 9') of the first and second electrodes (4, 6).

6. The voltage sensor according to one of claims 1 to 5, **characterised in that** the modulating elements (9, 9', 9") each have a length of about 10 mm to about 60 mm and a diameter of about 1 mm to about 10 mm.

7. The voltage sensor according to one of claims 1 to 6, **characterised in that** the modulating elements (9) of the first electrode (4) and the modulating elements (9') of the second electrode (2) do not have an overlap region along their direction of longitudinal extent.

8. The voltage sensor according to one of claims 1 to 7, **characterised in that** the modulating elements (9, 9', 9") each have a substantially electrically insulating base body (10) and an electrically conductive coating (11).

9. The voltage sensor according to one of claims 1 to 8, **characterised in that** the modulating elements (9, 9', 9") each comprise an electrically conductive additive and a substantially electrically insulating base compound, the additive preferably comprising or consisting of carbon nanoparticles.

10. The voltage sensor according to one of claims 1 to 9, **characterised in that** the modulating elements (9") of the third electrode (8) at least partially, preferably completely, overlap the modulating elements (9, 9') of the first and second electrodes (4, 6) in their direction of longitudinal extent.

11. The voltage sensor according to one of claims 1 to 10, **characterised in that** the first electrode (4) and the second electrode (6) each have six to fourteen, preferably eight to twelve, modulating elements (9, 9'), and **in that** the third electrode (8) has 14 to 26, preferably 18 to 22, modulating elements (9").

12. The voltage sensor according to one of claims 1 to 11, **characterised in that** the capacitor arrangement has a capacitance of 0.1 pF to 30 pF, preferably 0.5 pF to 15 pF, at a temperature of 20 °C, a relative humidity of 50 %, a pressure of 1000 mbar and a power frequency of 50 Hz.

13. The voltage sensor according to one of claims 1 to 12, **characterised in that** the core region (2) comprises a dielectric comprising or consisting of a siloxane-based polymer.

14. A voltage dividing device, comprising a voltage sensor (1) according to one of claims 1 to 13.

15. An arrangement of a voltage dividing device according to claim 14 at a connecting element of a switchgear of an electric grid.

## Revendications

1. Capteur de tension (1) avec un terminal électrique haute tension (5), une borne de signal électrique ainsi que une borne de mise à la terre (7), le capteur de tension (1) comprenant une partie centrale (2) avec une résistance électrique (3) disposée dans celle-ci et un ensemble de condensateurs disposé dans celle-ci, l'ensemble de condensateurs étant noyé dans un diélectrique et
- ayant une première électrode (4) qui est reliée au terminal haute tension (5),
- ayant une deuxième électrode (6) qui est reliée à la borne de signal,
- la première électrode (4) et la deuxième électrode (6) étant reliées électriquement par la résistance électrique (3),
- l'ensemble de condensateurs comprenant une troisième électrode (8) connectée à la borne de mise à la terre (7),
**caractérisé en ce que**
- la première électrode (4), la deuxième électrode (6) et la troisième électrode (8) comprennent chacune plusieurs éléments de modulation (9, 9', 9") électroconducteurs en forme de tige avec une section transversale ronde, qui s'étendent parallèlement à l'axe longitudinal (13) du capteur de tension (1), et **en ce que**
- les éléments de modulation (9, 9', 9") sont conçus de telle sorte qu'ils migrent avec le diélectrique au cours du processus de production et en cas de variations de température.

2. Capteur de tension selon la revendication 1, **caractérisé en ce que** les éléments de modulation (9, 9', 9") sont disposés de manière circulaire et de préférence de manière sensiblement concentrique les uns par rapport aux autres.

3. Capteur de tension selon la revendication 2, **caractérisé en ce que** les éléments de modulation (9) de la première électrode (4) et les éléments de modulation (9') de la deuxième électrode (6) sont disposés sensiblement dans le même rayon, de préférence dans un rayon d'environ 8 mm à environ 22 mm.

4. Capteur de tension selon la revendication 2 ou 3, **caractérisé en ce que** les éléments de modulation (9") de la troisième électrode (8) sont disposés dans un rayon à l'extérieur des éléments de modulation (9, 9') des premières et deuxièmes électrodes (4, 6), de préférence dans un rayon dans la plage d'environ 15 mm à environ 40 mm.

5. Capteur de tension selon la revendication 4, **caractérisé en ce que** le rayon de la disposition circulaire des éléments de modulation (9") de la troisième électrode (8) est supérieur d'environ 50% au rayon de la disposition circulaire des éléments de modulation (9, 9') des premières et deuxièmes électrodes (4, 6).

6. Capteur de tension selon l'une des revendications 1 à 5, **caractérisé en ce que** les éléments de modulation (9, 9', 9") présentent chacun une longueur d'environ 10 mm à environ 60 mm et un diamètre d'environ 1 mm à environ 10 mm.

7. Capteur de tension selon l'une des revendications 1 à 6, **caractérisé en ce que** les éléments de modulation (9) de la première électrode (4) et les éléments de modulation (9') de la deuxième électrode (6) ne présentent pas de zone de superposition le long de leur direction d'extension longitudinale.

8. Capteur de tension selon l'une des revendications 1 à 7, **caractérisé en ce que** les éléments de modulation (9, 9', 9") ont chacun un corps de base (10) sensiblement électriquement isolant et un revêtement (11) électroconducteur.

9. Capteur de tension selon l'une des revendications 1 à 8, **caractérisé en ce que** les éléments de contrôle (9, 9', 9") comprennent chacun un additif électroconducteur et une masse de base sensiblement électriquement isolante, l'additif comprenant de préférence des nanoparticules de carbone ou étant constitué de nanoparticules de carbone.

10. Capteur de tension selon l'une des revendications 1 à 9, **caractérisé en ce que** les éléments de modulation (9") de la troisième électrode (8) se superposent au moins partiellement, de préférence complètement, aux éléments de modulation (9, 9') des premières et deuxièmes électrodes (4, 6) dans leur direction d'extension longitudinale.

11. Capteur de tension selon l'une des revendications 1 à 10, **caractérisé en ce que** la première électrode (4) et la deuxième électrode (6) ont chacune six à quatorze, de préférence huit à douze, éléments de modulation (9, 9'), et **en ce que** la troisième électrode (8) a 14 à 26, de préférence 18 à 22, éléments de modulation (9").

12. Capteur de tension selon l'une des revendications 1 à 11, **caractérisé en ce que** l'ensemble de condensateurs présente une capacité de 0,1 pF à 30 pF, de préférence de 0,5 pF à 15 pF, à une température de 20 °C, une humidité relative de 50 %, une pression de 1000 mbar et une fréquence de courant de 50 Hz.

13. Capteur de tension selon l'une des revendications 1 à 12, **caractérisé en ce que** la partie centrale (2) comprend un diélectrique comprenant un polymère à base de siloxane ou constitué d'un polymère à base de siloxane.

14. Dispositif de division de tension, comprenant un capteur de tension (1) selon l'une des revendications 1 à 13.

15. Disposition d'un dispositif de division de tension selon la revendication 14 sur un raccord d'un appareillage d'un réseau électrique.
